# EUROPÄISCHE PATENTSCHRIFT

(11) **EP 3 526 814 B1**
(45) Veröffentlichungstag und Bekanntmachung des Hinweises auf die Patenterteilung: **18.05.2022**
(21) Anmeldenummer: 17837868.3
(22) Anmeldetag: 15.12.2017
(51) Int. Cl.: H01L 23/373, H01L 23/367

(54) **HALBLEITERMODUL MIT STÜTZSTRUKTUR AUF DER UNTERSEITE**
SEMICONDUCTOR MODULE WITH SUPPORT STRUCTURE ON THE BOTTOM
MODULE À SEMI-CONDUCTEURS COMPRENANT UNE STRUCTURE DE SUPPORT SUR LA FACE INFÉRIEURE

(30) Priorität: 20.12.2016 EP 16205389
(43) Veröffentlichungstag der Anmeldung: 21.08.2019
(73) Patentinhaber: Siemens Aktiengesellschaft, 80333 München (DE)
(72) Erfinder: NEUGEBAUER, Stephan, 91058 Erlangen (DE); PFEFFERLEIN, Stefan, 90562 Heroldsberg (DE); WERNER, Ronny, 90419 Nürnberg (DE)
(86) Internationale Anmeldenummer: PCT/EP2017/082992
(87) Internationale Veröffentlichungsnummer: WO 2018/114651

(56) Entgegenhaltungen:
- WO-A1-2007/045112
- WO-A1-2013/108718
- DE-A1-102004 019 442
- DE-T5-112015 000 141

## Beschreibung

Die vorliegende Erfindung geht aus von einem Halbleitermodul,
- wobei das Halbleitermodul ein aus einem elektrisch isolierenden Material bestehendes Substrat aufweist,
- wobei auf eine Oberseite des Substrats eine strukturierte Metallschicht aufgebracht ist, über die mindestens ein elektrisches Bauelement kontaktiert wird,
- wobei die strukturierte Metallschicht nur in einem Zentralbereich des Substrats auf das Substrat aufgebracht ist, so dass auf der Oberseite des Substrats ein den Zentralbereich umgebender Randbereich verbleibt, in dem die strukturierte Metallschicht nicht auf das Substrat aufgebracht ist,
- wobei auf eine Unterseite des Substrats im Zentralbereich eine Kontaktschicht zum Kontaktieren eines Kühlkörpers aufgebracht ist, die der strukturierten Metallschicht gegenüber liegt.

Derartige Halbleitermodule sind allgemein bekannt. Es kann beispielsweise auf die US 2016/0 021 729 A1 verwiesen werden.

Aus der US 2009/0 213 546 A1 ist ein Halbleitermodul bekannt, das ein aus einem elektrisch isolierenden Material bestehendes Substrat aufweist. Auf eine Oberseite des Substrats ist eine strukturierte Metallschicht aufgebracht, über die mindestens ein elektrisches Bauelement kontaktiert wird. Die strukturierte Metallschicht ist auf die gesamte Oberseite aufgebracht. Auf eine Unterseite des Substrats ist - im Wesentlichen deckungsgleich mit der strukturierten Metallschicht - eine Kontaktschicht zum Kontaktieren eines Kühlkörpers aufgebracht.

Aus der US 2014/0 204 533 A1 ist ein Halbleitermodul bekannt, das ein aus einem elektrisch isolierenden Material bestehendes Substrat aufweist. Auf eine Oberseite des Substrats ist eine strukturierte Metallschicht aufgebracht, über die mindestens ein elektrisches Bauelement kontaktiert wird. Die strukturierte Metallschicht scheint nur in einem Zentralbereich des Substrats auf das Substrat aufgebracht zu sein, so dass auf der Oberseite des Substrats ein den Zentralbereich umgebender Randbereich verbleibt, in dem die strukturierte Metallschicht nicht auf das Substrat aufgebracht ist. Auf eine Unterseite des Substrats ist eine Kontaktschicht zum Kontaktieren eines Kühlkörpers aufgebracht. Aus der US 2014/0 204 533 A1 geht nicht eindeutig hervor, in welchem Bereich der Unterseite die Kontaktschicht auf die Unterseite aufgebracht ist.

Aus der US 2010/0 302 741 A1 ist ein Halbleitermodul bekannt, das ein aus einem elektrisch isolierenden Material bestehendes Substrat aufweist. Auf eine Oberseite des Substrats ist eine strukturierte Metallschicht aufgebracht, über die mindestens ein elektrisches Bauelement kontaktiert wird. Die strukturierte Metallschicht ist nur in einem Zentralbereich des Substrats auf das Substrat aufgebracht, so dass auf der Oberseite des Substrats ein den Zentralbereich umgebender Randbereich verbleibt, in dem die strukturierte Metallschicht nicht auf das Substrat aufgebracht ist. Auf eine Unterseite des Substrats ist im Zentralbereich und auch noch ein Stück darüber hinaus eine Kontaktschicht zum Kontaktieren eines Kühlkörpers aufgebracht, die der strukturierten Metallschicht gegenüber liegt.

Aus der US 2013/0 056 185 A1 ist ein Halbleitermodul bekannt, das ein aus einem elektrisch isolierenden Material bestehendes Substrat aufweist. Auf eine Oberseite des Substrats ist eine strukturierte Metallschicht aufgebracht, über die mindestens ein elektrisches Bauelement kontaktiert wird. Die strukturierte Metallschicht ist nur in einem Zentralbereich des Substrats auf das Substrat aufgebracht, so dass auf der Oberseite des Substrats ein den Zentralbereich umgebender Randbereich verbleibt, in dem die strukturierte Metallschicht nicht auf das Substrat aufgebracht ist. Auf eine Unterseite des Substrats ist eine Kontaktschicht zum Kontaktieren eines Kühlkörpers aufgebracht, die der strukturierten Metallschicht gegenüber liegt. Die Kontaktschicht scheint sich über die gesamte Unterseite zu erstrecken.

Darüber hinaus offenbart die WO 2013/108718 A1 ein Halbleitermodul, welches relevanter Stand der Technik zu der vorliegenden Lehre ist.

Die Halbleitermodule können im Rahmen der vorliegenden Erfindung insbesondere als Leistungs-Halbleitermodule ausgebildet sein und als elektrisches Bauelement einen Leistungs-Halbleiter beispielsweise einen IGBT oder ein ähnliches Bauelement umfassen, beispielsweise einen Leistungs-MOSFET. Derartige Halbleitermodule können beispielsweise bei Elektroautos zum Schalten der Energieversorgung von Fahrmotoren verwendet werden. Auch können die Halbleitermodule als elektrisches Bauelement beispielsweise eine Leistungs-LED oder einen Widerstand umfassen.

Im Rahmen der Herstellung des Halbleitermoduls wird oftmals in einem Teilschritt mittels eines Presswerkzeugs Druck auf die Oberseite des Substrats ausgeübt. Der Druck auf die Oberseite wird von dem Presswerkzeug oftmals über ein flexibles Ausgleichsmaterial ausgeübt. Gleichzeitig mit dem Ausüben des Druckes wird das Substrat an seiner Unterseite mittels eines Halteelements gehalten. Oftmals erfolgt in Verbindung mit dem Ausüben des Druckes auch eine Beaufschlagung mit einer erhöhten Temperatur, beispielsweise in einem Sintervorgang.

Aufgrund des Überstandes des Substrats über die strukturierte Metallschicht werden im Rahmen des oben genannten Teilschrittes auch auf den Randbereich Druckkräfte ausgeübt. Wenn auf die Unterseite des Substrats die Kontaktschicht nur im Zentralbereich aufgebracht ist, werden auf den Übergang vom Zentralbereich zum Randbereich oftmals erhebliche Biegekräfte ausgeübt. Dies kann - insbesondere aufgrund der oftmals gegebenen hohen Sprödigkeit des Substrats - zu einem Bruch des Substrats führen. Auch können die Biegekräfte zu Rissen im Substrat führen, die zunächst zwar unbemerkt bleiben, später jedoch zu einem vorzeitigen Ausfall des Halbleitermoduls führen. Es ist denkbar, die Form des Halteelements derart zu gestalten, dass seine der Unterseite des Substrats zugewandte Seite im Randbereich eine Erhöhung aufweist, so dass das Halteelement das Substrat nicht nur im Bereich der Kontaktschicht, sondern auch im Randbereich stützt. Dies erfordert jedoch eine spezielle, dem jeweiligen Substrat angepasste Gestaltung des Halteelements. Insbesondere bei kleinen Stückzahlen ist diese Vorgehensweise ineffizient. Weiterhin muss in diesem Fall das Substrat relativ zum Halteelement exakt positioniert werden. Weiterhin ist es schwierig, das Substrat mit der für eine derartige Ausgestaltung des Halteelements erforderlichen Genauigkeit zu fertigen. So kann beispielsweise die Dicke der Kontaktschicht vom Substrat zu Substrat Schwankungen unterworfen sein.

Es ist weiterhin denkbar, das Substrat entsprechend dick zu gestalten, so dass die Biegekräfte innerhalb des tolerierbaren Rahmens bleiben. Aufgrund der größeren Dicke des Substrats erhöht sich in diesem Fall jedoch der thermische Widerstand des Substrats, so dass das Halbleiterbauelement schlechter entwärmt werden kann.

Im Stand der Technik ist weiterhin bekannt, die Kontaktschicht über die gesamte Unterseite zu erstrecken. Durch diese Vorgehensweise werden überhöhte Biegebeanspruchungen durch den Prozessdruck beim Herstellen des Halbleitermoduls vermieden. Jedoch werden zum einen für den zuverlässigen Betrieb erforderliche Luftstrecken verringert. Weiterhin weist das Material, aus dem die Kontaktschicht besteht, in der Regel einen anderen Wärmeausdehnungskoeffizienten auf als das Substrat. Dies führt bei einer Änderung der Temperatur, wie sie im Betrieb unvermeidlich ist, zu einem Bimetalleffekt und damit zu einem Verbiegen des Halbleitermoduls. Derartige Verbiegungen können beispielsweise zu einer verringerten Auflagefläche mit einem Kühlkörper und damit einer reduzierten Kühlung des Halbleitermoduls führen. Im Extremfall können die Verbiegungen sogar zu einem Bruch des Substrats führen. Auch andere Effekte wie beispielsweise ein Pumpen von Hilfs- oder Betriebsstoffen wie beispielsweise einer Wärmeleitpaste können auftreten.

Die Aufgabe der vorliegenden Erfindung besteht darin, ein Halbleitermodul zu schaffen, bei dem eine übermäßige Biegebeanspruchung sowohl beim Herstellen des Halbleitermoduls als auch im Betrieb des Halbleitermoduls auf einfache Weise und zuverlässig vermieden wird.

Die Aufgabe wird durch ein Halbleitermodul mit den Merkmalen des Anspruchs 1 gelöst. Vorteilhafte Ausgestaltungen des Halbleitermoduls sind Gegenstand der abhängigen Ansprüche 2 bis 8.

Erfindungsgemäß wird ein Halbleitermodul der eingangs genannten Art dadurch ausgestaltet, dass auf die Unterseite des Substrats im Randbereich eine strukturierte Stützstruktur aufgebracht ist, deren Dicke mit der Dicke der Kontaktschicht korrespondiert.

Dadurch wird im Rahmen der Herstellung des Halbleitermoduls gewährleistet, dass das Substrat auch im Randbereich gegen die von dem Presswerkzeug ausgeübten Druckkräfte abgestützt wird. Verbiegungen können daher nicht oder zumindest nur in unwesentlichem Umfang auftreten. Im späteren Betrieb des Halbleitermoduls können durch die strukturierte Stützstruktur Vibrationen verringert werden. Aufgrund der Strukturierung der Stützstruktur ist es jedoch möglich, Biegekräfte, die aufgrund von Temperaturänderungen im Betrieb auftreten, minimal zu halten. Weiterhin kann im Betrieb des Halbleitermoduls verhindert werden, dass es aufgrund von Schwingungen zu unerwünschten mechanischen Kontakten oder sogar einem Bruch des Substrats kommt.

Zudem weist die Stützstruktur mehrere Strukturelemente auf, wobei entweder sich zwischen den Strukturelementen nur eine Überbrückungsstruktur mit einer gegenüber den Strukturelementen deutlich reduzierten Dicke befindet oder die Strukturelemente vollständig voneinander getrennt sind. Durch diese Ausgestaltung können im Betrieb des Halbleitermoduls auftretende Biegekräfte in besonders großem Umfang minimiert werden.

Im Übergangsbereich zwischen der Stützstruktur und den Bereichen, in denen nur die Überbrückungsstruktur vorhanden ist oder die Strukturelemente vollständig voneinander getrennt sind, kann eine Kerbwirkung auftreten. Dabei weist bezüglich jedes beliebigen Teilbereichs der Stützstruktur die Stützstruktur an ihrem der Unterseite zugewandten Ende einen anfänglichen Querschnitt und an ihrem von der Unterseite abgewandten Ende einen verbleibenden Querschnitt auf und nimmt weiterhin der Querschnitt mit zunehmendem Abstand von der Unterseite zunächst monoton ab, bis der Querschnitt einen Minimalquerschnitt aufweist. Die Abnahme kann insbesondere streng monoton erfolgen. Hierdurch kann die Kerbwirkung minimiert werden.

In einer bevorzugten Ausgestaltung des Halbleitermoduls ist die Stützstruktur von der Kontaktschicht getrennt. Dadurch können Kriech- und Luftstrecken aufrechterhalten bzw. maximiert werden.

Vorzugsweise erstrecken sich die Strukturelemente jeweils nur über einen Teil der Länge und der Breite der Unterseite. Diese Ausgestaltung bewirkt insbesondere, dass durch ein einzelnes der Strukturelemente bewirkte Biegekräfte nur auf einen begrenzten Bereich des Substrats wirken. Die Strukturelemente können insbesondere in Längsrichtung und Breitenrichtung der Unterseite jeweils mehrere Reihen bilden.

Die Minimierung der oben beschriebenen Kerbwirkung kann vorzugsweise dadurch weiter optimiert werden, dass die Abnahme des Querschnitts an der Unterseite maximal ist und sich mit zunehmendem Abstand von der Unterseite verlangsamt.

In einer besonders bevorzugten Ausgestaltung nimmt weiterhin mit noch weiter zunehmendem Abstand von der Unterseite der Querschnitt wieder monoton zu. Die Zunahme kann insbesondere streng monoton sein. Durch diese Ausgestaltung kann die Kontaktfläche zum Halteelement und später zu einem Kühlkörper maximiert werden. Analog zur vorherigen Abnahme kann die Zunahme in der Nähe des minimalen Querschnitts minimal sein und sich mit zunehmendem Abstand von der Unterseite vergrößern.

Zwischen die Strukturelemente kann ein Hilfsstoff eingebracht sein. Durch diese Ausgestaltung kann beispielsweise der Wärmeübergang von der Unterseite des Substrats auf einen an die Kontaktschicht angesetzten Kühlkörper optimiert werden. Zwischenräume zwischen den Strukturelementen können in diesem Fall weiterhin als Pufferspeicher zur temporären Aufnahme des Hilfsstoffs während des Betriebs des Halbleitermoduls dienen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: einen Querschnitt durch ein Halbleitermodul,
- FIG 2: eine Draufsicht auf eine Oberseite eines Substrats,
- FIG 3: eine Draufsicht auf eine Unterseite des Substrats,
- FIG 4: eine mögliche Gestaltung einer Stützstruktur,
- FIG 5: eine mögliche Gestaltung eines Strukturelements.

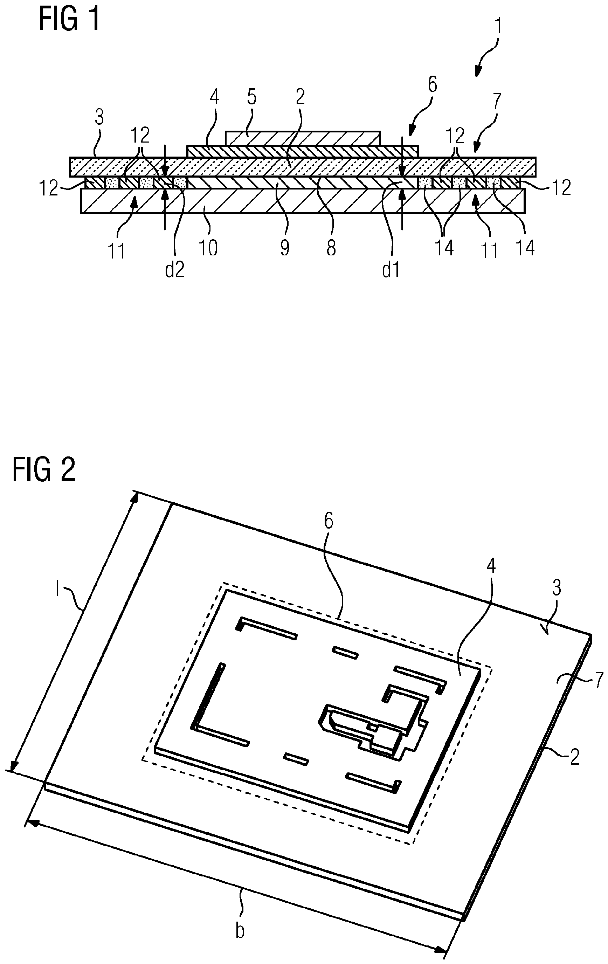

Gemäß FIG 1 weist ein Halbleitermodul 1 ein Substrat 2 auf. Das Substrat 2 besteht aus einem elektrisch isolierenden Material. Das Substrat 2 kann beispielsweise aus Aluminiumnitrid (AlN) , Aluminiumoxid (Al₂O₃), Siliziumnitrid (Si₃N₄) oder einem anderen keramischen Material bestehen.

Auf eine Oberseite 3 des Substrats 2 ist gemäß den FIG 1 und 2 eine strukturierte Metallschicht 4 aufgebracht. Die Metallschicht 4 besteht in der Regel aus Kupfer. Alternativ kann die Metallschicht 4 beispielsweise aus Aluminium bestehen.

Auch kann die Metallschicht 4 beispielsweise ihrerseits mehrere Schichten umfassen, insbesondere eine direkt auf die Oberseite 3 des Substrats 2 aufgebrachte Schicht aus Aluminium und eine auf die Schicht aus Aluminium aufgebrachte Schicht aus Kupfer. Über die strukturierte Metallschicht 4 wird mindestens ein elektrisches Bauelement 5, beispielsweise ein IGBT oder ein MOSFET, elektrisch und thermisch kontaktiert. Die mechanische, elektrische und thermische Kontaktierung erfolgt in der Regel über eine in den FIG nicht dargestellte Lötschicht, Sinterschicht, Leitklebeschicht oder dergleichen. Die strukturierte Metallschicht 4 ist nur in einem Zentralbereich 6 des Substrats 2 auf das Substrat 2 aufgebracht. Auf der Oberseite 3 des Substrats 2 verbleibt somit ein Randbereich 7, der den Zentralbereich 6 umgibt. Im Randbereich 7 ist die strukturierte Metallschicht 4 nicht auf das Substrat 2 aufgebracht.

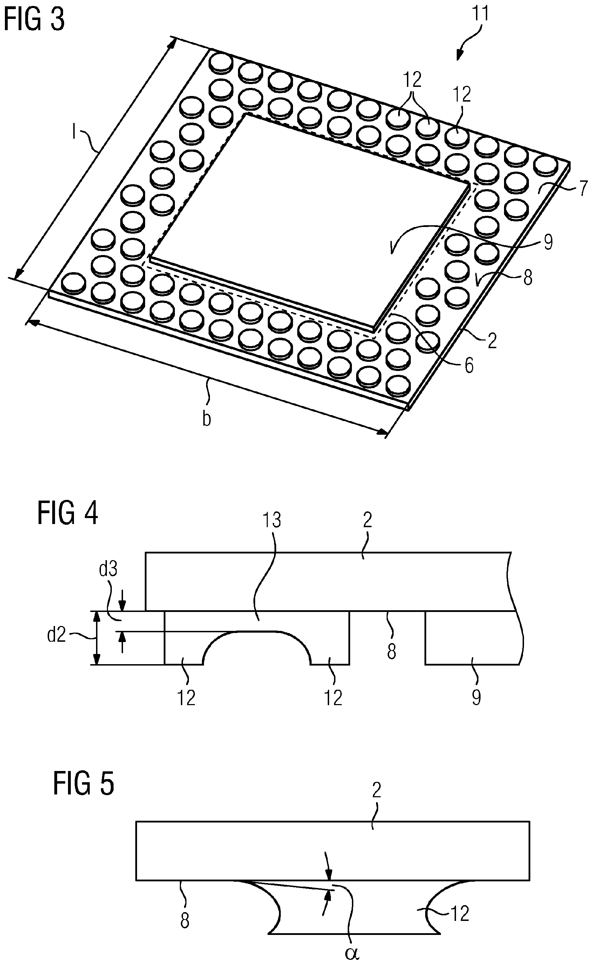

Auf eine Unterseite 8 des Substrats 2 ist gemäß den FIG 1 und 3 im Zentralbereich 6 eine Kontaktschicht 9 aufgebracht. Die Kontaktschicht 9 dient der Kontaktierung eines Kühlkörpers 10. Die Kontaktschicht 9 liegt der strukturierten Metallschicht 4 gegenüber. Sie befindet sich also im Zentralbereich 6. Sie kann entsprechend der Darstellung in FIG 3 unstrukturiert sein. Die Kontaktschicht 9 kann - analog zur strukturierten Metallschicht - ebenfalls aus Metall bestehen. Die obigen Ausführungen zu den möglichen Materialien der strukturierten Metallschicht 4 gelten in analoger Weise auch für die Kontaktschicht 9. Die Kontaktschicht 9 weist eine Dicke d1 auf.

Das Substrat 2 einschließlich der strukturierten Metallschicht 4 und der Kontaktschicht 9 ist vorzugsweise als sogenanntes DBC-Substrat (Direct Bonded Copper) oder als AMB-Substrat (Active Metal Brazing) ausgebildet.

Weiterhin ist entsprechend der Darstellung in den FIG 1 und 3 auf die Unterseite 8 des Substrats 2 im Randbereich 7 eine strukturierte Stützstruktur 11 aufgebracht. Die strukturierte Stützstruktur 11 weist eine Dicke d2 auf. Die Dicke d2 korrespondiert - zumindest im Wesentlichen - mit der Dicke d1 der Kontaktschicht 9. Im Idealfall sind die beiden Dicken d1, d2 exakt gleich groß. In manchen Fällen ist es jedoch tolerierbar oder unter Umständen sogar von Vorteil, wenn die Dicke d2 geringfügig - maximal 20%, besser maximal 10% - größer oder kleiner als die Dicke d1 ist.

Die Strukturierung der Stützstruktur 11 bewirkt, dass die Stützstruktur 11 nicht als geschlossene Schicht vorhanden ist, sondern unterbrochen ist. Die Stützstruktur 11 weist also mehrere Strukturelemente 12 auf.

Die Art der Strukturierung kann verschieden gestaltet sein. So ist es beispielsweise möglich, dass die Stützstruktur 11 in Form von Mäandern, Rauten, Kästchen oder andersartige Stützstruktur 11 mit zusammenhängenden Strukturelementen 12 ausgebildet ist. Insbesondere in diesen Fällen können die einzelnen Strukturelemente 12 der Stützstruktur 11 direkt miteinander verbunden sein. Die Stützstruktur 11 bildet in diesem Fall zwar eine zusammenhängende Struktur. Die zusammenhängende Struktur bildet jedoch ein relativ filigranes Muster, welches den Randbereich 7 nur teilweise ausfüllt. Der Füllgrad - also das Verhältnis zwischen von der Stützstruktur 11 eingenommener Fläche des Randbereichs 7 und der Gesamtfläche des Randbereichs 7 - ist in diesem Fall jedoch relativ gering. In der Regel liegt er maximal bei 20%, meist sogar maximal bei 10%. Alternativ ist es entsprechend der Darstellung in den FIG 1 und 3 möglich, dass die Strukturelemente 12 vollständig voneinander getrennt sind. Auch in diesem Fall kann der Füllgrad einen relativ geringen Wert aufweisen, beispielsweise maximal 20% oder sogar maximal 10%. Im Falle voneinander getrennter Strukturelemente 12 kann der Füllgrad jedoch auch einen größeren Wert aufweisen, beispielsweise 30%, 50% oder im Einzelfall auch mehr als 50%.

Es ist entsprechend der schematischen Darstellung in FIG 4 möglich, dass sich zwischen den Strukturelementen 12 eine Überbrückungsstruktur 13 befindet. In diesem Fall weist die Überbrückungsstruktur 13 jedoch eine Dicke d3 auf, die gegenüber der Dicke d2 der Strukturelemente 12 deutlich reduziert ist. Die Reduzierung beträgt mindestens 50%, vorzugsweise mindestens 80% der Dicke d2. in diesem Fall kann beispielsweise zunächst eine einheitliche Schicht auf die Unterseite 8 aufgebracht worden sein, von der sodann im Bereich der Überbrückungsstruktur 13 Material abgetragen wurde. Die Bereiche, in denen kein Material abgetragen wurde, bildet in diesem Fall die Stützstruktur 11. Alternativ ist es möglich, dass keine Überbrückungsstruktur 13 vorhanden ist. Insbesondere kann beispielsweise das zuvor als einheitliche Schicht aufgetragene Material im Bereich zwischen den Strukturelementen 12 der Stützstruktur 11 vollständig abgetragen werden.

Wie bereits erwähnt, können die einzelnen Strukturelemente 12 der Stützstruktur 11 direkt miteinander verbunden sein. In diesem Fall sind die Strukturelemente 12 von der gegebenenfalls vorhandenen Überbrückungsstruktur 13 nur teilweise umgeben. Vorzugsweise sind die Strukturelemente 12 jedoch entsprechend der Darstellung in den FIG 1 und 3 voneinander getrennt, so dass sie von der gegebenenfalls vorhandenen Überbrückungsstruktur 13 vollständig umgeben sind.

Vorzugsweise erstrecken die Strukturelemente 12 sich entsprechend der Darstellung in FIG 3 jeweils nur über einen Teil der Länge l und der Breite b der Unterseite 8. Insbesondere können die Strukturelemente 12 entsprechend der Darstellung in FIG 3 in Längsrichtung und Breitenrichtung der Unterseite 8 jeweils mehrere Reihen bilden.

In der Darstellung gemäß FIG 3 weisen die Strukturelemente 12 einen kreisförmigen Querschnitt auf. Alternativ könnten die Strukturelemente 12 ebenso als Ringe ausgebildet sein, d.h. einen kreisförmigen Querschnitt mit einer zentralen, ebenfalls kreisförmigen Ausnehmung aufweisen. Auch können Strukturelemente 12 beispielsweise als Ovale oder als Ellipsen - mit oder ohne zentrale Ausnehmung - und eventuell auch als eckige Struktur (Viereck, Sechseck, ...) - mit oder ohne zentrale Ausnehmung - ausgebildet sein. Die Aufzählung ist selbstverständlich nur rein beispielhaft.

Es ist möglich, dass der Querschnitt der einzelnen Strukturelemente 12 mit zunehmendem Abstand von der Unterseite 8 konstant bleibt. Wenn entsprechend der Darstellung in FIG 3 - rein beispielhaft - die Strukturelemente 12 einen kreisförmigen Querschnitt aufweisen, wären die Strukturelemente 12 in diesem Fall also zylindrisch ausgebildet. Vorzugsweise weisen die Strukturelemente 12 jedoch an ihrem der Unterseite 8 zugewandten Ende einen anfänglichen Querschnitt und an ihrem von der Unterseite 8 abgewandten Ende einen verbleibenden Querschnitt auf, wobei weiterhin der Querschnitt mit zunehmendem Abstand von der Unterseite 8 zunächst monoton abnimmt. Die Abnahme kann insbesondere streng monoton sein. Wenn entsprechend der Darstellung in FIG 3 - rein beispielhaft - die Querschnitte kreisförmig sind, könnten die Strukturelemente 12 in diesem Fall also beispielsweise kegelstumpfartig ausgebildet sein. Noch besser ist es, wenn die Abnahme des Querschnitts an der Unterseite 8 maximal ist und sich mit zunehmendem Abstand von der Unterseite 8 verlangsamt. Wenn entsprechend der Darstellung in FIG 3 - rein beispielhaft - die Querschnitte kreisförmig sind, könnten die Strukturelemente 12 in diesem Fall also beispielsweise entsprechend der Darstellung in FIG 5 in der Nähe der Unterseite 8 ähnlich einem Vulkankegel ausgebildet sein. Optimal ist es hierbei, wenn die Strukturelemente 12 an ihrem der Unterseite 8 zugewandten Ende nahezu völlig flach auslaufen. Ein Winkel a, den die Strukturelemente 12 an der Unterseite 8 aufweisen, sollte also möglichst klein sein.

Die Abnahme des Querschnitts erfolgt, bis der Querschnitt einen Minimalquerschnitt aufweist. Danach kann mit noch weiter zunehmendem Abstand von der Unterseite 8 der Querschnitt konstant bleiben. Bevorzugt nimmt der Querschnitt wieder monoton zu. Analog zur vorherigen Abnahme des Querschnitts kann die Zunahme insbesondere streng monoton sein. In der Regel ist die Zunahme des Querschnitts jedoch geringer als die vorherige Abnahme des Querschnitts. Der verbleibende Querschnitt ist also in der Regel kleiner als der anfängliche Querschnitt.

Die obigen, in Verbindung mit einem einzelnen Strukturelement 12 erläuterten bevorzugten Ausgestaltungen sind nicht nur für die einzelnen Strukturelemente 12 gültig. Sie gelten vorzugsweise für jeden beliebigen Teilbereich der Stützstruktur 11.

Insbesondere in dem Fall, dass die Stützstruktur 11 zwar eine zusammenhängende Struktur bildet, die zusammenhängende Struktur 11 jedoch ein filigranes Muster bildet, ist es möglich, dass die Stützstruktur 11 auch mit der Kontaktschicht 9 verbunden ist. Vorzugsweise ist die Stützstruktur 11 von der Kontaktschicht 9 jedoch getrennt, kontaktiert diese also nicht direkt. Durch diese Ausgestaltung können insbesondere Kriech- und Luftstrecken maximiert werden.

Es ist entsprechend der Darstellung in FIG 1 möglich, dass zwischen die Strukturelemente 12 ein Hilfsstoff 14 eingebracht ist. Der Hilfsstoff 14 kann beispielsweise eine Wärmeleitpaste sein. Dadurch kann die Wärmeabfuhr vom Substrat 2 und damit im Ergebnis vom Halbleitermodul 1 maximiert werden.

Zusammengefasst betrifft die vorliegende Erfindung somit folgenden Sachverhalt:
Ein Halbleitermodul 1 weist ein aus einem elektrisch isolierenden Material bestehendes Substrat 2 auf. Auf eine Oberseite 3 des Substrats 2 ist eine strukturierte Metallschicht 4 aufgebracht, über die mindestens ein elektrisches Bauelement 5 kontaktiert wird. Die strukturierte Metallschicht 4 ist nur in einem Zentralbereich 6 des Substrats 2 auf das Substrat 2 aufgebracht, so dass auf der Oberseite 3 des Substrats 2 ein den Zentralbereich 6 umgebender Randbereich 7 verbleibt, in dem die strukturierte Metallschicht 4 nicht auf das Substrat 2 aufgebracht ist. Auf eine Unterseite 8 des Substrats 2 ist im Zentralbereich 6 eine Kontaktschicht 9 zum Kontaktieren eines Kühlkörpers 10 aufgebracht, die der strukturierten Metallschicht 4 gegenüber liegt. Auf die Unterseite 8 des Substrats 2 ist weiterhin im Randbereich 7 eine strukturierte Stützstruktur 11 aufgebracht, deren Dicke d2 mit der Dicke d1 der Kontaktschicht 9 korrespondiert.

Die vorliegende Erfindung weist viele Vorteile auf. Insbesondere ist eine deutlich verbesserte Verarbeitung möglich. Die Gefahr eines Bruchs des Substrats 2 wird vermieden. Im Betrieb erhöht sich die Schwingungs- und Schockbeständigkeit. Die Wärmeleitung zum Kühlkörper 10 kann verbessert werden.

## Patentansprüche

1. Halbleitermodul,
- wobei das Halbleitermodul ein aus einem elektrisch isolierenden Material bestehendes Substrat (2) aufweist,
- wobei auf eine Oberseite (3) des Substrats (2) eine strukturierte Metallschicht (4) aufgebracht ist, über die mindestens ein elektrisches Bauelement (5) kontaktiert wird,
- wobei die strukturierte Metallschicht (4) nur in einem Zentralbereich (6) des Substrats (2) auf das Substrat (2) aufgebracht ist, so dass auf der Oberseite (3) des Substrats (2) ein den Zentralbereich (6) umgebender Randbereich (7) verbleibt, in dem die strukturierte Metallschicht (4) nicht auf das Substrat (2) aufgebracht ist,
- wobei auf eine Unterseite (8) des Substrats (2) im Zentralbereich (6) eine Kontaktschicht (9) zum Kontaktieren eines Kühlkörpers (10) aufgebracht ist, die der strukturierten Metallschicht (4) gegenüber liegt,
- wobei auf die Unterseite (8) des Substrats (2) im Randbereich (7) eine strukturierte Stützstruktur (11) aufgebracht ist, deren Dicke (d2) mit der Dicke (d1) der Kontaktschicht (9) korrespondiert,
**dadurch gekennzeichnet,**
- **dass** die Stützstruktur (11) mehrere Strukturelemente (12) aufweist,
- **dass** entweder sich zwischen den Strukturelementen (12) nur eine Überbrückungsstruktur (13) mit einer gegenüber den Strukturelementen (12) deutlich reduzierten Dicke (d3) befindet oder die Strukturelemente (12) vollständig voneinander getrennt sind und
- **dass** bezüglich jedes beliebigen Teilbereichs der Stützstruktur (11) die Stützstruktur (11) an ihrem der Unterseite (8) zugewandten Ende einen anfänglichen Querschnitt und an ihrem von der Unterseite (8) abgewandten Ende einen verbleibenden Querschnitt aufweist und dass der Querschnitt mit zunehmendem Abstand von der Unterseite (8) zunächst monoton abnimmt, insbesondere streng monoton abnimmt, bis der Querschnitt einen Minimalquerschnitt aufweist.

2. Halbleitermodul nach Anspruch 1,
**dadurch gekennzeichnet, dass** die Stützstruktur (11) von der Kontaktschicht (9) getrennt ist.

3. Halbleitermodul nach Anspruch 1 oder 2,
**dadurch gekennzeichnet, dass** die Strukturelemente (12) sich jeweils nur über einen Teil der Länge (l) und der Breite (b) der Unterseite (8) erstrecken.

4. Halbleitermodul nach Anspruch 3,
**dadurch gekennzeichnet, dass** die Strukturelemente (12) in Längsrichtung und Breitenrichtung der Unterseite (8) jeweils mehrere Reihen bilden.

5. Halbleitermodul nacheinem der vorherigen Ansprüche,
**dadurch gekennzeichnet, dass** die Abnahme des Querschnitts an der Unterseite (8) maximal ist und sich mit zunehmendem Abstand von der Unterseite (8) verlangsamt.

6. Halbleitermodul nacheinem der vorherigen Ansprüche,
**dadurch gekennzeichnet, dass** der Querschnitt, ausgehend vom minimalen Querschnitt, mit noch weiter zunehmendem Abstand von der Unterseite (8) wieder monoton zunimmt, insbesondere streng monoton zunimmt.

7. Halbleitermodul nach Anspruch 6,
**dadurch gekennzeichnet, dass** die Zunahme in der Nähe des minimalen Querschnitts minimal ist und sich mit zunehmendem Abstand von der Unterseite vergrößert.

8. Halbleitermodul nach einem der vorherigen Ansprüche,
**dadurch gekennzeichnet, dass** zwischen die Strukturelemente (12) ein Hilfsstoff eingebracht (14) ist.

## Claims

1. Semiconductor module,
- wherein the semiconductor module comprises a substrate (2) made from an electrically insulating material,
- wherein a structured metal layer (4), via which at least one electrical component (5) is contacted, is applied to a top side (3) of the substrate (2),
- wherein the structured metal layer (4) is applied to the substrate (2) only in a central region (6) of the substrate (2) such that an edge region (7) surrounding the central region (6) and in which the structured metal layer (4) is not applied to the substrate (2) is left on the top side (3) of the substrate (2),
- wherein a contact layer (9) for contacting a cooling body (10) and which is situated opposite the structured metal layer (4) is applied to the bottom side (8) of the substrate (2) in the central region (6),
- wherein a structured supporting structure (11), the thickness (d2) of which corresponds to the thickness (d1) of the contact layer (9), is applied to the bottom side (8) of the substrate (2) in the edge region (7),
**characterized**
- **in that** the supporting structure (11) has a plurality of structure elements (12),
- **in that** either only a bridging structure (13) with a significantly reduced thickness (d3) compared with the structure elements (12) is situated between the structure elements (12) or the structure elements (12) are completely separate from one another, and
- **in that**, with respect to any part region of the supporting structure (11), the supporting structure (11) has an initial cross-section at its end facing the bottom side (8) and a remaining cross-section at its end facing away from the bottom side (8), and in that the cross-section decreases at first monotonously, in particular strictly monotonously, the greater the distance from the bottom side (8) until the cross-section has a minimum cross-section.

2. Semiconductor module according to Claim 1,
**characterized in that** the supporting structure (11) is separate from the contact layer (9).

3. Semiconductor module according to Claim 1 or 2,
**characterized in that** the structure elements (12) extend in each case only over part of the length (1) and the width (b) of the bottom side (8).

4. Semiconductor module according to Claim 3,
**characterized in that** the structure elements (12) in each case form a plurality of rows lengthwise and widthwise on the bottom side (8).

5. Semiconductor according to one of the preceding claims,
**characterized in that** the decrease of the cross-section is at its maximum on the bottom side (8) and is more gradual the greater the distance from the bottom side (8).

6. Semiconductor module according to one of the preceding claims,
**characterized in that**, starting from the minimum cross-section, the cross-section increases again monotonously, in particular increases strictly monotonously, the greater the distance from the bottom side (8).

7. Semiconductor module according to Claim 6,
**characterized in that** the increase is at its minimum in the vicinity of the minimum cross-section and increases the greater the distance from the bottom side.

8. Semiconductor module according to one of the preceding claims,
**characterized in that** an auxiliary material (14) is introduced between the structure elements (12).

## Revendications

1. Module à semiconducteur,
- dans lequel le module à semiconducteur a un substrat (2) en un matériau isolant du point de vue électrique,
- dans lequel sur une face (3) supérieure du substrat (2) est déposée une couche (4) métallique structurée, par laquelle au moins un composant (5) électrique est mis en contact,
- dans lequel la couche (4) métallique structurée n'est déposée sur le substrat (2) que dans une partie (6) centrale du substrat (2), de manière à laisser subsister sur la face (3) supérieure du substrat (2) une partie (7) de bord entourant la partie (6) centrale, partie (7) de bord, dans laquelle la couche (4) métallique structurée n'est pas déposée sur le substrat (2),
- dans lequel sur une face (8) inférieure du substrat (2) dans la partie (6) centrale est déposée, pour la mise en contact d'un puits de chaleur (10), une couche (9) de contact, qui fait face à la couche (4) métallique structurée,
- dans lequel sur la face (8) inférieure du substrat (2), dans la partie (7) de bord, est déposée une structure (11) d'appui structurée, dont l'épaisseur (d2) correspond à l'épaisseur (d1) de la couche (9) de contact,
**caractérisé**
- **en ce que** la structure (11) d'appui a plusieurs éléments (12) de structure,
- **en ce que** ou bien il se trouve, entre les aimants (12) de structure, seulement une structure (13) de pontage ayant une épaisseur (d3) nettement réduite par rapport aux éléments (12) de structure, ou bien les éléments (12) de structure sont séparés complètement les uns des autres et
- **en ce que**, en ce qui concerne chaque région partielle quelconque de la structure (11) d'appui, la structure (11) d'appui a à son extrémité, tournée vers la face (8) inférieure, une section transversale initiale et à son extrémité, loin de la face (8) inférieure, une section transversale restante et en ce que la section transversale au fur et à mesure qu'augmente la distance à la face (8) inférieure, diminue d'abord de manière monotone, diminue notamment de manière strictement monotone, jusqu'à ce que la section transversale ait une section transversale minimum.

2. Module à semiconducteur suivant la revendication 1,
**caractérisé en ce que** sa structure (11) d'appui est séparée de la couche (9) de contact.

3. Module à semiconducteur suivant la revendication 1 ou 2,
**caractérisé en ce que** les éléments (12) de structure s'étendent respectivement seulement sur une partie de la longueur (1) et de la largeur (b) de la face (8) inférieure.

4. Module à semiconducteur suivant la revendication 3,
**caractérisé en ce que** les éléments (12) de structure forment respectivement plusieurs rangées dans la direction longitudinale et la direction en largeur de la face (8) inférieure.

5. Module à semiconducteur suivant l'une des revendications précédentes,
**caractérisé en ce que** la diminution de la section transversale est maximum sur la face (8) inférieure et se ralentit au fur et à mesure qu'augmente la distance à la face (8) inférieure.

6. Module à semiconducteur suivant l'une des revendications précédentes,
**caractérisé en ce que** la section transversale, à partir de la section transversale minimum, réaugmente de manière monotone au fur et à mesure qu'augmente encore la distance à la face (8) inférieure, en augmentant notamment de manière strictement monotone.

7. Module à semiconducteur suivant la revendication 6,
**caractérisé en ce que** l'augmentation est minimum au voisinage de la section transversale minimum et s'agrandit au fur et à mesure qu'augmente la distance à la face inférieure.

8. Module à semiconducteur suivant l'une des revendications précédentes,
**caractérisé en ce qu'**une substance auxiliaire est introduite (14) entre les éléments (12) de structure.
